# FASCICULE DE BREVET EUROPEEN

(11) **EP 3 069 390 B1**
(45) Date de publication et mention de la délivrance du brevet: **30.01.2019**
(21) Numéro de dépôt: 14805987.6
(22) Date de dépôt: 27.10.2014
(51) Int. Cl.: H01L 37/02, H01L 41/317, H01L 41/45

(54) **PROCEDE DE FABRICATION D'UN DISPOSITIF PYROELECTRIQUE ET/OU PIEZOELECTRIQUE**
VERFAHREN ZUR HERSTELLUNG EINER PYROELEKTRISCHEN UND/ODER PIEZOELEKTRISCHEN VORRICHTUNG
PROCESS FOR MANUFACTURING A PYROELECTRIC AND/OR PIEZOELECTRIC DEVICE

(30) Priorité: 15.11.2013 FR 1361162
(43) Date de publication de la demande: 21.09.2016
(73) Titulaire: Commissariat à l'Énergie Atomique et aux Énergies Alternatives, 75015 Paris (FR)
(72) Inventeur: ALIANE, Abdelkader, 38100 Grenoble (FR)
(74) Mandataire: Cabinet Beaumont
(86) Numéro de dépôt international: PCT/FR2014/052725
(87) Numéro de publication internationale: WO 2015/071567

(56) Documents cités:
- WO-A1-2005/064653
- KR-A- 20090 030 825
- KR-A- 20100 046 641
- US-A1- 2009 306 264
- DA SILVA A B ET AL: "Effect of drawing on the dielectric properties and polarization of pressed solution cast beta-PVDF films", JOURNAL OF MATERIALS SCIENCE, vol. 45, no. 15, 23 avril 2010 (2010-04-23), pages 4206-4215, XP019821684, ISSN: 1573-4803

## Description

La présente demande concerne un procédé de fabrication d'un dispositif pyroélectrique et/ou piézoélectrique comprenant un film de polyfluorure de vinylidène (PVDF) ou d'un copolymère du PVDF et un dispositif pyroélectrique et/ou piézoélectrique obtenu par un tel procédé.

### Exposé de l'art antérieur

Les dispositifs pyroélectriques et/ou piézoélectriques peuvent être utilisés comme capteurs, par exemple comme capteurs de pression, comme interrupteurs ou comme dispositifs de récupération d'énergie. Il est connu de réaliser un dispositif pyroélectrique et/ou piézoélectrique en utilisant un film polymère de PVDF ou d'un copolymère du PVDF.

Le polymère PVDF et les copolymères du PVDF sont des polymères semi-cristallins, qui après l'étape de polymérisation, ont une cristallinité généralement comprise entre 50 % et 60 %. Le polymère PVDF ou le copolymère du PVDF peut comprendre des phases cristallines de trois types α, β et γ. La phase β peut présenter des propriétés pyroélectriques et piézoélectriques tandis que la phase α n'en présente pas.

Après l'étape de polymérisation, la phase cristalline obtenue est généralement en majorité la phase α. Un traitement supplémentaire doit alors généralement être prévu pour transformer au moins en partie la phase α en phase β. Ce traitement peut comprendre :
un recuit thermique, par exemple à une température comprise entre 110° C et 170° C pendant une durée variant de plusieurs minutes à plusieurs heures ;
l'étirement mécanique du polymère, voir Da Silva et al, J Mater Sci (2010) 45:4206-4215 ;
l'application au film d'un champ électrique d'intensité élevée pendant plusieurs heures ; et/ou
l'ionisation de l'air autour du film PVDF ; ou
l'addition d'un halogénure métallique, voir KR 2009 0030825 A. KR 2010 0046641 A divulgue un procédé de fabrication d'un film ferro/pyro/piézo-électrique, comprenant le dépôt d'une solution comprenant un solvant et un composé du PVDF, et l'irradiation d'une partie avec un rayonnement ultraviolet continue.

Il peut être souhaitable de former le film de PVDF ou d'un copolymère du PVDF sur un substrat d'un matériau plastique, par exemple du polyéthylène naphtalate (PEN) ou du polyéthylène téréphtalate (PET). Il peut, en outre, être souhaitable de former le film de PVDF ou d'un copolymère du PVDF sur un substrat sur lequel ou dans lequel sont également réalisés d'autres composants électroniques, par exemple des transistors.

Un inconvénient des procédés connus d'obtention de la phase cristalline β est qu'ils peuvent ne pas être compatibles avec l'utilisation d'un substrat plastique ou avec la formation de composants électroniques, notamment en raison des températures élevées et/ou des contraintes mécaniques appliquées.

### Résumé

Un mode de réalisation vise à pallier les inconvénients des procédés de fabrication des dispositifs pyroélectriques et/ou piézoélectriques décrits précédemment.

Un autre mode de réalisation vise la fabrication d'un dispositif pyroélectrique et/ou piézoélectrique comprenant un film de PVDF ou d'un copolymère du PVDF sur un substrat plastique.

Un autre mode de réalisation vise la fabrication d'un dispositif pyroélectrique et/ou piézoélectrique comprenant un film de PVDF ou d'un copolymère du PVDF sur un substrat sur lequel ou dans lequel sont également formés d'autres composants électroniques.

Un autre mode de réalisation vise à réduire la durée de la fabrication d'un film à base de PVDF pyroélectrique et/ou piézoélectrique.

Un autre mode de réalisation vise à réduire, voire supprimer, l'étape du chauffage du substrat.

Ainsi, un mode de réalisation prévoit un procédé de fabrication d'un dispositif piézoélectrique et/ou pyroélectrique comprenant un film comprenant du polyfluorure de vinylidène et/ou au moins un copolymère du polyfluorure de vinylidène, le procédé comprenant les étapes suivantes :
former au moins une portion d'une couche d'une solution comprenant un solvant et un composé comprenant du polyfluorure de vinylidène et/ou au moins le copolymère du polyfluorure de vinylidène ; et
irradier au moins la portion avec des impulsions d'au moins un rayonnement ultraviolet.

Selon un mode de réalisation, le composé comprend un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

Selon un mode de réalisation, le composé comprend, en outre, des particules en céramique.

Selon un mode de réalisation, la durée de chaque impulsion est comprise entre 500 µs et 2 ms.

Selon un mode de réalisation, la fluence du rayonnement ultraviolet est comprise entre 10 J/cm² et 25 J/cm².

Selon un mode de réalisation, le solvant a une température d'évaporation comprise entre 110 °C et 140 °C.

Selon un mode de réalisation, la solution comprend de 80 % à 95 % en poids du solvant et de 5 % à 20 % en poids du composé.

Selon un mode de réalisation, le procédé comprend, en outre, les étapes suivantes :
prévoir un substrat ;
déposer sur le substrat un revêtement réfléchissant le rayonnement ultraviolet ; et
former le film au moins partiellement sur le revêtement.

Selon un mode de réalisation, le solvant est adapté à absorber au moins partiellement le rayonnement ultraviolet.

Un mode de réalisation prévoit un dispositif piézoélectrique et/ou pyroélectrique comprenant un film comprenant du polyfluorure de vinylidène et/ou au moins un copolymère du polyfluorure de vinylidène et ayant deux phases cristallines β ayant des orientations différentes.

Selon un mode de réalisation, le dispositif comprend un substrat, sur lequel est formé le film, en un polymère ayant une température de transition vitreuse inférieure ou égale à 130 °C.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1D sont des coupes, partielles et schématiques, des structures obtenues à des étapes successives d'un mode de réalisation d'un procédé de fabrication d'un dispositif pyroélectrique/piézoélectrique de PVDF ou d'un copolymère du PVDF ;
la figure 2 représente un diagramme de diffraction X obtenu pour un film d'un copolymère du PVDF réalisé selon un procédé de fabrication connu et d'un film d'un copolymère de PVDF réalisé selon le mode de réalisation décrit en relation avec les figures 1A à 1D ;
la figure 3 représente des courbes d'évolution de la tension obtenue aux bornes d'un dispositif pyroélectrique et/ou piézoélectrique en fonction de la pression appliquée pour un dispositif comprenant un film d'un copolymère du PVDF réalisé selon un procédé de fabrication connu et un dispositif comprenant un film d'un copolymère du PVDF réalisé selon le mode de réalisation décrit en relation avec les figures 1A à 1D ; et
la figure 4 représente une courbe d'évolution du coefficient pyroélectrique en fonction de la température d'un dispositif comprenant un film d'un copolymère du PVDF réalisé selon le mode de réalisation décrit en relation avec les figures 1A à 1D.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. De plus, seuls les éléments utiles à la compréhension de la présente description ont été représentés et sont décrits. Dans la suite de la description, sauf indication contraire, les termes "sensiblement", "environ" et "de l'ordre de" signifient "à 10 % près". Dans la suite de la description, l'expression élément "à base de PVDF" signifie un élément comprenant au moins 70 % en poids du polymère PVDF et/ou d'au moins un copolymère du PVDF.

Un mode de réalisation d'un procédé de fabrication d'un dispositif pyroélectrique et/ou piézoélectrique comprenant un film à base de PVDF vise notamment à former la phase cristalline β qui présente les propriétés piézoélectrique et/ou pyroélectrique souhaitées, en appliquant des impulsions brèves d'un rayonnement ultraviolet (UV) sur une couche liquide comprenant un composé à base de PVDF. Ceci permet de chauffer la couche liquide pour favoriser la formation de la phase cristalline β. Ceci permet de chauffer localement la couche liquide sans chauffer le substrat sur lequel le film à base de PVDF est formé et/ou sans chauffer des composants électroniques voisins du film à base de PVDF.

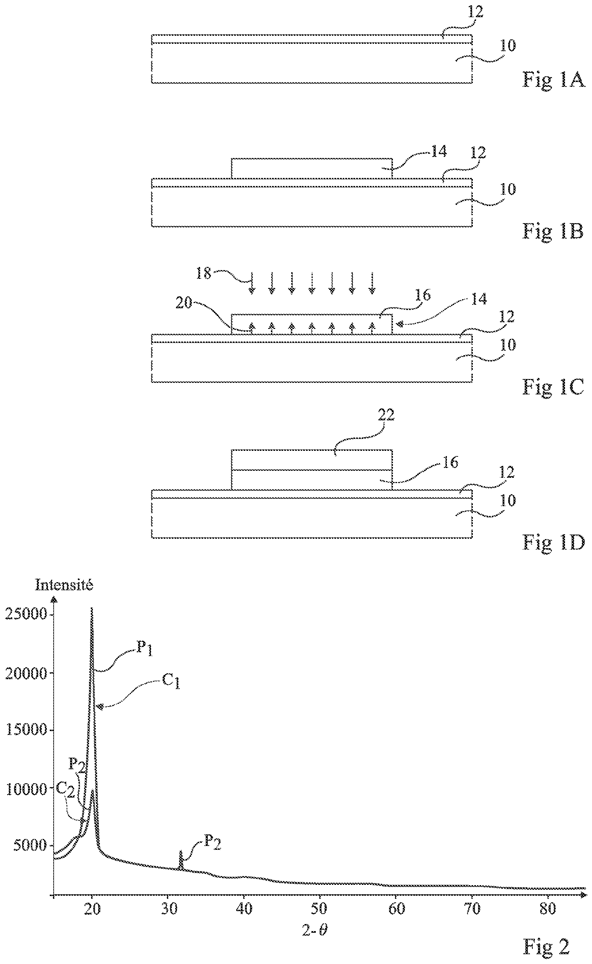

Les figures 1A à 1D illustrent un mode de réalisation d'un procédé de fabrication d'un dispositif pyroélectrique et/ou piézoélectrique comprenant un film à base de PVDF.

La figure 1A est une coupe, partielle et schématique, de la structure obtenue après avoir formé une première électrode 12 sur un substrat 10.

Le substrat 10 peut être en un matériau isolant ou semiconducteur. A titre d'exemple, le substrat 10 est réalisé en verre, en silicium, ou dans une matière plastique. Le substrat 10 peut être réalisé en un polymère, par exemple un polyimide, du PEN ou du PET. A titre d'exemple, l'épaisseur du substrat 10 est comprise entre 25 µm et 200 µm. Le substrat 10 peut être flexible.

La première électrode 12 est, de préférence, en un matériau réfléchissant le rayonnement ultra-violet, par exemple sur une plage de longueurs d'onde comprises entre 200 nm et 400 nm. Il peut s'agir d'une couche métallique. A titre d'exemple, le matériau composant la couche 12 est choisi parmi le groupe comprenant l'argent (Ag), l'aluminium (Al), l'or (Au) ou un mélange ou un alliage de deux ou plus de deux de ces métaux. L'épaisseur de la couche 12 peut être supérieure ou égale à 30 nm, de préférence comprise entre 30 nm et 300 nm.

Le dépôt de la première électrode 12 sur le substrat 10 peut être réalisé par un dépôt physique en phase vapeur ou par des techniques d'impression, notamment par sérigraphie ou par impression à jet d'encre, ou par pulvérisation.

La figure 1B représente la structure obtenue après avoir déposé une portion d'une couche liquide 14, éventuellement visqueuse, sur la première électrode 12. La portion de couche liquide 14 comprend un solvant et un composé à base de PVDF dissous dans le solvant. L'épaisseur de la portion 14 est comprise entre 100 nm et 4 µm.

Le composé à base de PVDF peut comprendre le seul polymère PVDF, un seul copolymère du PVDF, un mélange de deux ou plus de deux copolymères du PVDF, un mélange du polymère PVDF et d'au moins un copolymère du PVDF. De préférence, le copolymère du PVDF est le poly(fluorure de vinylidène - tri fluoro éthylène) (P(VDF-TrFE)), le poly(fluorure de vinylidène-tétrafluoroéthylène), notamment le P(VDFₓ-TrFE₁₀₀₋ₓ) où x est un nombre réel compris entre 60 et 80, le poly(fluorure de vinylidène - trifluoroéthylène - chlorofluoroéthylène) (P(VDF-TrFE-CFE)), le poly(fluorure de vinylidène - trifluoroéthylène - chlorotrifluoro éthylène) (P(VDF-TrFE-CTFE)).

Le composé à base de PVDF peut, en outre, comprendre des charges. Les charges peuvent correspondre à des particules céramiques, par exemple des particules de titanate de baryum (BaPiO₃), des particules de zirconate titanate de plomb (PbZrTiO₃ ou PZT), des particules de titanate de plomb (PbTiO₃) ou des particules de tantalate de lithium (LiTaO₃). La concentration en poids de charges dans le composé à base de PVDF peut varier de 5 % à 25 %.

Le composé peut donc comprendre un mélange du polymère PVDF et d'au moins une céramique ou un mélange d'au moins un copolymère du PVDF et d'au moins une céramique, par exemple les mélanges suivants : PVDF/BaTiO₃, P(VDF-TrFE)/BaTiO₃, P(VDF-TrFE-CTFE)/BaTiO₃, P(VDF-TrFE-CFE)/BaTiO₃, PVDF/PbZrTiO₃, P(VDF-TrFE)/PbZrTiO₃, P(VDF-TrFE-CTFE)/PbZrTiO₃, P(VDF-TrFE-CFE)/PbZrTiO₃, PVDF/PbTiO₃, P(VDF-TrFE)/PbTiO₃, P(VDF-TrFE-CTFE)/PbTiO₃, P(VDF-TrFE-CFE)/PbTiO₃, PVDF/LiTaO₃, P(VDF-TrFE)/LiTaO₃, P(VDF-TrFE-CTFE)/LiTaO₃, P(VDF-TrFE-CFE)/LiTaO₃.

De préférence, le solvant est un solvant polaire. Ceci permet, de façon avantageuse, d'améliorer la dissolution du polymère à base de PVDF. De préférence, le solvant est adapté à absorber, au moins partiellement, le rayonnement UV, par exemple sur une plage de longueurs d'onde comprises entre 200 nm et 400 nm. Selon un mode de réalisation, la température d'évaporation du solvant est comprise entre 110 °C et 140 °C, de préférence entre 110 °C et 130 °C, plus préférentiellement entre 120 °C et 130 °C. Le solvant peut être choisi parmi le groupe comprenant le cyclopentanone, le dyméthylsulphoxide (DMSO), le dyméthylformamide (DMF), le dyméthylacétamide (DMAc) ou le N-méthyl-E-pyrrolidone (NMP). De préférence, le solvant est le cyclopentanone.

La portion 14 comprend de 1 % à 30 %, de préférence de 1 % à 20 %, en poids du composé à base de PVDF et de 70 % à 99 %, de préférence de 80 % à 99 %, en poids du solvant. De façon avantageuse, la concentration en poids du solvant est choisie pour ajuster la viscosité de la solution obtenue afin de permettre la mise en oeuvre de techniques d'impression. Le procédé de formation de la portion de couche liquide 14 peut correspondre à un procédé dit additif, par exemple par impression directe de la portion 14 aux emplacements souhaités, par exemple par impression par jet d'encre, héliographie, sérigraphie, flexographie, revêtement par pulvérisation (en anglais spray coating) ou dépôt de gouttes (en anglais drop-casting). Le procédé de formation de la portion de couche liquide 14 peut correspondre à un procédé dit soustractif, dans lequel la couche liquide est déposée sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie.

La figure 1C illustre une étape d'irradiation d'au moins une partie de la portion 14, ce qui entraîne la formation d'un film 16 à base de PVDF ayant les propriétés pyroélectriques et/ou piézoélectriques souhaitées. L'irradiation aux rayons UV est représentée de façon schématique en figure 1C par les flèches 18. L'irradiation est réalisée par une succession d'impulsions de rayonnement UV, ou flashs ultraviolets. Par rayonnement UV, on entend un rayonnement dont les longueurs d'onde sont, au moins en partie, comprises entre 200 nm et 400 nm. Selon un mode de réalisation, la durée d'une impulsion UV est comprise entre 500 µs et 2 ms. La durée entre deux impulsions UV successives peut être comprise entre 1 et 5 secondes. La fluence du rayonnement (UV) peut être comprise entre 10 J/cm² et 25 J/cm². Le nombre d'impulsions UV dépend notamment de l'épaisseur de la portion 14. A titre d'exemple, pour une épaisseur de la portion 14 de 100 nm, le nombre d'impulsions UV peut être de l'ordre de 1 à 2 avec une fluence entre 10 J/cm² et 15 J/cm² et pour une épaisseur de la portion 14 de l'ordre de 4 µm, le nombre d'impulsions UV peut être de l'ordre de 2 à 6 avec une fluence entre 17 J/cm² et 21 J/cm².

De façon avantageuse, pendant l'irradiation de la portion 14, la première électrode 12 réfléchit une partie du rayonnement UV ayant traversé la portion 14. Ceci permet d'améliorer la quantité de rayonnement UV reçue par la portion 14. La réflexion des rayons UV est représentée de façon schématique en figure 1C par les flèches 20.

De façon avantageuse, le solvant de la portion de couche liquide 14 absorbe au moins en partie le rayonnement UV. Ceci permet d'améliorer le chauffage du composé à base d'UV et de favoriser la formation de la phase cristalline β. La température d'évaporation du solvant est avantageusement supérieure à 110 °C pour éviter une évaporation trop rapide du solvant avant la formation de la phase cristalline β qui se produit entre 120 °C et 130 °C.

De préférence, l'étape d'irradiation entraîne une évaporation de plus de 50 % en poids, de préférence de plus de 80 % en poids, du solvant de la portion de couche liquide 14.

La figure 1D représente la structure obtenue après avoir déposé une deuxième électrode 22 sur le film 16. L'électrode 22 est, par exemple, en un matériau métallique choisi parmi le groupe comprenant l'argent, le cuivre ou un mélange ou un alliage d'au moins deux de ces matériaux. Selon le matériau considéré, l'électrode 22 peut être déposée par un dépôt physique en phase vapeur (PVD) ou par des techniques d'impression, par exemple par impression par jet d'encre ou par sérigraphie. Dans ce cas, une étape de recuit peut alors être prévue, par exemple par irradiation de l'encre déposée par impulsions UV ayant une fluence comprise entre 15 J/cm² et 25 J/cm².

Une étape ultérieure d'application d'un champ électrique à la structure peut être prévue. A titre d'exemple, le champ électrique peut varier entre 20 et 80 V/pm et peut être appliqué à une température comprise entre 70 et 90 °C pendant 5 à 10 minutes.

Le film 16 obtenu par la mise en oeuvre du mode de réalisation du procédé de fabrication décrit précédemment a des propriétés pyroélectrique et piézoélectrique.

La figure 2 représente deux diagrammes de diffraction C₁ et C₂ respectivement de premier et deuxième films à base de PVDF.

Le premier film piézoélectrique associé à la courbe C₁ a été obtenu en formant une couche de 2 µm d'épaisseur par dépôt par sérigraphie d'une solution comprenant 20 % en poids du copolymère P(VDF₇₀-TrFe₃₀) et 80 % en poids de cyclopentanone. La solution a été obtenue en mélangeant 2 g de cyclopentanone et 0,4 g de poudre de P(VDF₇₀-TrFe₃₀) à une température comprise entre 40 et 45 °C pendant plusieurs heures. La couche a été chauffée sur une plaque chauffante 5 minutes à 100 °C et 3 minutes à 130 °C.

Le deuxième film piézoélectrique associé à la courbe C₂ a été obtenu par le mode de réalisation du procédé de fabrication décrit précédemment en relation avec les figures 1A à 1D, dans lequel la portion de couche liquide 14 avait une épaisseur de 2 µm et a été formée en déposant par sérigraphie une solution comprenant 80 % en poids de cyclopentanone et 20 % en poids du copolymère P(VDF₇₀-TrFe₃₀). La solution a été obtenue en mélangeant 0,4 g de poudre de P(VDF₇₀-TrFe₃₀) avec 2 g de cyclopentanone à une température comprise entre 40 et 45 °C pendant plusieurs heures. La couche a été irradiée par 2 impulsions d'un rayonnement UV fourni par une lampe UV dont la longueur d'onde était comprise entre 240 nm et 1000 nm, avec plus de 75 % de l'énergie entre 240 nm et 400 nm. La durée de chaque impulsion était de 2 ms. La durée entre deux impulsions successives était de 1 seconde. La fluence du rayonnement UV était de 21 J/cm².

La courbe C₁ comprend un pic P₁ pour un angle de 2θ₁ sensiblement égal à 20°. Ceci indique la présence d'une phase cristalline β dans le premier film, caractéristique de propriétés pyroélectrique/piézoélectrique.

La courbe C₂ comprend également un pic P₂ pour l'angle de 2θ₁. Toutefois, la courbe C₂ comprend, en outre, un pic P₂ pour un angle 2θ₂ sensiblement égal à 32°, plus précisément à 31,5° à 1 % près. Ceci traduit la présence d'une autre phase cristalline β dans le deuxième film qui a une orientation différente de la phase cristalline β associée à l'angle 2θ₁. L'étape d'irradiation par flash UV permet la formation d'au moins deux phases cristallines β dans le deuxième film.

Les inventeurs ont mis en évidence une amélioration de l'activité piézoélectrique et/ou pyroélectrique d'un film obtenu par le mode de réalisation du procédé de fabrication décrit précédemment en relation avec les figures 1A à 1D par rapport à un film piézoélectrique et/ou pyroélectrique obtenu par chauffage.

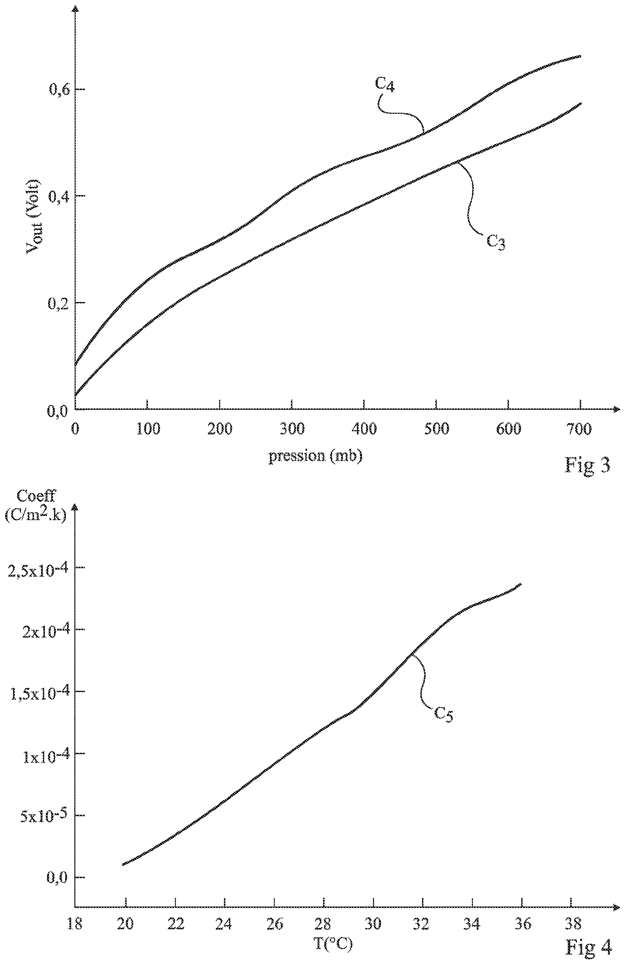

La figure 3 représente des courbes d'évolution C₃ et C₄ de la tension appliquée entre les bornes de capteurs piézoélectriques comprenant respectivement des troisième et quatrième films à base de PVDF.

Le troisième film piézoélectrique associé à la courbe C₃ a été obtenu en formant une couche de 2 µm d'épaisseur par sérigraphie d'une solution comprenant 80 % en poids de cyclopentanone et 20 % en poids du copolymère P(VDF₇₀-TrFe₃₀). La solution a été obtenue en mélangeant 0,4 g de poudre de P(VDF₇₀-TrFe₃₀) avec 2 g de cyclopentanone à une température comprise entre 40 et 45°C pendant plusieurs heures. La couche a été chauffée 30 minutes à 130 °C après son dépôt.

Le quatrième film piézoélectrique associé à la courbe C₄ a été obtenu par le mode de réalisation du procédé de fabrication décrit précédemment en relation avec les figures 1A à 1D, dans lequel la portion de couche liquide 14 avait une épaisseur de 2 µm et a été formée en déposant par sérigraphie une solution comprenant 80 % en poids de cyclopentanone et 20 % en poids du copolymère P(VDF₇₀-TrFe₃₀). La solution a été obtenue en mélangeant 0,4 g de poudre de P(VDF₇₀-TrFe₃₀) avec 2 g de cyclopentanone à une température comprise entre 40 et 45°C pendant plusieurs heures. La couche a été irradiée par 4 impulsions d'un rayonnement UV fourni par une lampe UV dont la longueur d'onde était comprise entre 240 nm et 1000 nm, avec plus de 75 % de l'énergie entre 240 nm et 400 nm. La durée de chaque impulsion était de 1,5 ms. La durée entre deux impulsions successives était de 1 seconde. La fluence du rayonnement UV était de 17,5 J/cm².

La courbe C₄ est située au-dessus de la courbe C₃. Ceci signifie que l'activité piézoélectrique du capteur comprenant le quatrième film à base de PVDF est supérieure à l'activité piézoélectrique du capteur comprenant le troisième film à base de PVDF.

La figure 4 représente une courbe d'évolution C₅ du coefficient pyroélectrique Coeff d'un capteur pyroélectrique comprenant le quatrième film à base de PVDF. La courbe C₅ illustre l'activité pyroélectrique du film à base de PVDF fabriqué selon le mode de réalisation du procédé de fabrication décrit précédemment selon les figures 1A à 1D.

Un avantage du mode de réalisation du procédé de fabrication du dispositif pyroélectrique/piézoélectrique est qu'il a une durée courte, en particulier inférieure à 1 minute. En outre, il ne comprend pas d'étape de chauffage de l'ensemble du substrat sur lequel le film à base de PVDF est formé à une température supérieure à 130 °C. Ceci permet l'utilisation d'un substrat en matière plastique. Ceci permet, en outre, de réaliser d'autres composants électroniques dans et/ou sur le substrat.

Un avantage du mode de réalisation du procédé de fabrication du dispositif pyroélectrique/piézoélectrique est que le traitement pour former la phase cristalline β, comprenant un recuit thermique, l'application de contraintes mécaniques et/ou l'application d'un champ magnétique, peut ne pas être présent.

Des modes de réalisation particuliers ont été décrits. Diverses variantes et modifications apparaîtront à l'homme de l'art.

## Revendications

1. Procédé de fabrication d'un dispositif piézoélectrique et/ou pyroélectrique comprenant un film (16) comprenant du polyfluorure de vinylidène et/ou au moins un copolymère du polyfluorure de vinylidène, le procédé comprenant les étapes suivantes :
former au moins une portion (14) d'une couche d'une solution comprenant un solvant et un composé comprenant du polyfluorure de vinylidène et/ou au moins le copolymère du polyfluorure de vinylidène ; et
irradier au moins la portion avec des impulsions d'au moins un rayonnement ultraviolet.

2. Procédé selon la revendication 1, dans lequel le composé comprend un polymère choisi parmi le groupe comprenant le polyfluorure de vinylidène, le poly(fluorure de vinylidène - tri fluoro éthylène), le poly(fluorure de vinylidène - tétra fluoro éthylène) et un mélange d'au moins deux de ces polymères.

3. Procédé selon la revendication 1 ou 2, dans lequel le composé comprend, en outre, des particules en céramique.

4. Procédé selon l'une quelconque des revendications 1 à 3, dans lequel la durée de chaque impulsion est comprise entre 500 µs et 2 ms.

5. Procédé selon l'une quelconque des revendications 1 à 4, dans lequel la fluence du rayonnement ultraviolet est comprise entre 10 J/cm² et 25 J/cm².

6. Procédé selon l'une quelconque des revendications 1 à 5, dans lequel le solvant a une température d'évaporation comprise entre 110 °C et 140 °C.

7. Procédé selon l'une quelconque des revendications 1 à 6, dans lequel la solution comprend de 80 % à 95 % en poids du solvant et de 5 % à 20 % en poids du composé.

8. Procédé selon l'une quelconque des revendications 1 à 7, comprenant, en outre, les étapes suivantes :
prévoir un substrat (10) ;
déposer sur le substrat un revêtement (12) réfléchissant le rayonnement ultraviolet ; et
former le film (16) au moins partiellement sur le revêtement.

9. Procédé selon l'une quelconque des revendications 1 à 8, dans lequel le solvant est adapté à absorber au moins partiellement le rayonnement ultraviolet.

10. Dispositif piézoélectrique et/ou pyroélectrique comprenant un film (16) comprenant du polyfluorure de vinylidène et/ou au moins un copolymère du polyfluorure de vinylidène,
**caractérisé en ce qu'**il comprend deux phases cristallines β ayant des orientations différentes, l'une des phases cristallines β correspondant, dans un diagramme de diffraction X, à un angle 2θ égal à 31,5° à 1 % près.

11. Dispositif selon la revendication 10, comprenant un substrat (10), sur lequel est formé le film (16), en un polymère ayant une température de transition vitreuse inférieure ou égale à 130 °C.

## Patentansprüche

1. Verfahren zur Herstellung einer piezoelektrischen und/oder pyroelektrischen Vorrichtung, die einen Film (16) aufweist, der Poly-Vinylidenfluorid und/oder wenigstens ein Co-Polymer von Poly-Vinylidenfluorid aufweist, wobei das Verfahren die folgenden Schritte aufweist:
Ausbilden von wenigstens einem Teil (14) einer Schicht einer Lösung, die ein Lösungsmittel und eine Verbindung aufweist, die Poly-Vinylidenfluorid und/oder wenigstens das Co-Polymer von Poly-Vinylidenfluorid aufweist; und
Bestrahlen wenigstens des Teils mit Impulsen von wenigstens einer ultravioletten Strahlung.

2. Verfahren nach Anspruch 1, wobei die Verbindung ein Polymer aufweist, das ausgewählt ist aus der Gruppe, die Poly-Vinylidenfluorid, Poly-(Vinylidenfluorid - Trifluorethylen), Poly-(Vinylidenfluorid - tetrafluorethylen) und einem Gemisch von wenigstens zwei dieser Polymere aufweist.

3. Verfahren nach Anspruch 1 oder 2, wobei die Verbindung ferner Keramikpartikel aufweist.

4. Verfahren nach einem der Ansprüche 1 bis 3, wobei die Dauer jedes Impulses in dem Bereich von 500 µs bis 2 ms liegt.

5. Verfahren nach einem der Ansprüche 1 bis 4, wobei die Fluenz der ultravioletten Strahlung in dem Bereich von 10 J/cm² bis 25 J/cm² liegt.

6. Verfahren nach einem der Ansprüche 1 bis 5, wobei das Lösungsmittel eine Verdampfungstemperatur zwischen 110°C und 140°C aufweist.

7. Verfahren nach einem der Ansprüche 1 bis 6, wobei die Lösung 80 bis 95 Gew.% des Lösungsmittels und 5 bis 20 Gew.% der Verbindung aufweist.

8. Verfahren nach einem der Ansprüche 1 bis 7, das ferner die folgenden Schritte aufweist:
Vorsehen eines Substrats (10);
Abscheiden einer Beschichtung (12) auf dem Substrat, die die ultraviolette Strahlung reflektiert; und
Ausbilden des Films (16) wenigstens teilweise auf der Beschichtung.

9. Verfahren nach einem der Ansprüche 1 bis 8, wobei das Lösungsmittel geeignet ist, ultraviolette Strahlung wenigstens teilweise zu absorbieren.

10. Piezoelektrische und/oder pyroelektrische Vorrichtung, die einen Film (16) aufweist, der Poly-Vinylidenfluorid und/oder wenigstens ein Co-Polymer von Poly-Vinylidenfluorid aufweist, **dadurch gekennzeichnet, dass** es zwei β-kristalline Phasen mit unterschiedlichen Richtungen aufweist, wobei eine der β-kristallinen Phasen in einem Röntgenstrahlenbeugungsdiagramm gleich einem 2θ Winkel von 31,5° innerhalb von 1 % ist.

11. Vorrichtung nach Anspruch 10, die ein Substrat (10), auf dem der Film (16) ausgebildet ist, hergestellt aus einem Polymer mit einer Glasübergangstemperatur von weniger oder gleich 130°C, aufweist.

## Claims

1. A method of manufacturing a piezoelectric and/or pyroelectric device comprising a film (16) comprising polyvinylidene fluoride and/or at least one copolymer of polyvinylidene fluoride, the method comprising the steps of:
forming at least one portion (14) of a layer of a solution comprising a solvent and a compound comprising polyvinylidene fluoride and/or at least the copolymer of polyvinylidene fluoride; and
irradiating at least the portion with pulses of at least one ultraviolet radiation.

2. The method of claim 1, wherein the compound comprises a polymer selected from the group comprising poly-vinylidene fluoride, poly(vinylidene fluoride - trifluoro ethylene), poly(vinylidene fluoride - tetrafluoroethylene) and a mixture of at least two of these polymers.

3. The method of claim 1 or 2, wherein the compound further comprises ceramic particles.

4. The method of any of claims 1 to 3, wherein the duration of each pulse is in the range from 500 µs to 2 ms.

5. The method of any of claims 1 to 4, wherein the fluence of the ultraviolet radiation is in the range from 10 J/cm² to 25 J/cm².

6. The method of any of claims 1 to 5, wherein the solvent has an evaporation temperature in the range from 110°C to 140°C.

7. The method of any of claims 1 to 6, wherein the solution comprises from 80% to 95% wt. of the solvent and from 5% to 20% wt. of the compound.

8. The method of any of claims 1 to 7, further comprising the steps of:
providing a substrate (10);
depositing on the substrate a coating (12) reflecting the ultraviolet radiation; and
forming the film (16) at least partially on the coating.

9. The method of any of claims 1 to 8, wherein the solvent is capable of at least partially absorbing the ultraviolet radiation.

10. A pyroelectric and/or piezoelectric device comprising a film (16) comprising polyvinylidene fluoride and/or at least one copolymer of polyvinylidene fluoride, **characterized in that** it comprises two β crystalline phases having different directions, one of the β crystalline phases corresponding, in a X ray diffraction diagram, to a 2θ angle equal to 31.5° to within 1%.

11. The device of claim 10, comprising a substrate (10) having the film (16) formed thereon, made of a polymer having a glass transition temperature lower than or equal to 130°C.
